# EUROPEAN PATENT APPLICATION

(11) **EP 1 876 871 A2**
(43) Date of publication of application: **09.01.2008**
(21) Application number: 06127357.9
(22) Date of filing: 29.12.2006
(51) Int. Cl.: H05K 1/11

(54) **Surface mounting structure for electronic component**

(30) Priority: 04.07.2006 KR 20060062436
(71) Applicant: Samsung Electronics Co., Ltd., Suwon-si 442-742 Gyeonggi-do (KR)
(72) Inventor: Nagatani, Kaname, Seongnam-si, Gyeonggi-do (KR)
(74) Representative: Robinson, Ian Michael

(57) **Abstract**

A surface mounting structure for an electronic component (100) is provided. A lead (130) of the electronic component (100) is soldered to a land (200) including a first land portion (210) to which a bottom surface (131) of the lead (130) is soldered, and a second land portion (220) having a greater width than the first land portion (210) and to which an end portion (132) of the lead (130) is soldered. The structure ensures stability and reliability while utilizing a small area of a circuit board (120).

## Description

The present invention relates to a surface mounting structure for an electronic component. More particularly, the present invention relates to a surface mounting structure for attaching a lead of an electronic component to a land formed on a circuit board by soldering.

With the rapid development of information technology, miniaturized and enhanced devices such as mobile electronic devices are continuously emerging. The circuit boards mounted in such devices are also becoming more miniaturized. To mount various kinds of electronic components within the small area of these miniaturized circuit boards, a high-density surface mounting technology is being developed.

In a typical surface mounting process, a lead of an electronic component is soldered to a land on a circuit board through a reflow process. The solder reflow process includes the steps of applying a solder cream onto the land on the circuit board, positioning the lead, and applying heat to the solder cream. The solder cream fuses the lead to the land and forms a fillet between the lead and the land.

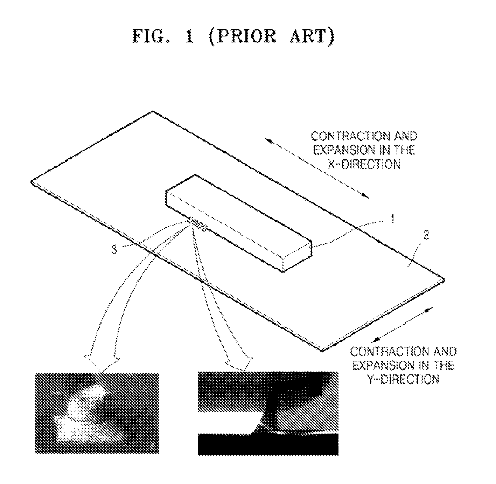

Figure 1 is a diagram showing images of a crack in a solder fillet of a conventional surface mounting structure. Referring to Figure 1, a crack can be seen in the solder fillet of lead 3. These cracks are created because the electronic component 1 which is surface mounted on the circuit board 2 has a different coefficient of thermal expansion than the circuit board 2. When the circuit board 2 and the electronic component 1 are subjected to repeated thermal cycles over a period of time (that is, they alternate between high and low temperatures), the circuit board 2 and the electronic component 1 repeatedly expand and contract different amounts, producing thermal stresses. The circuit board 2 and the electronic component 1 may expand and contract in the x-direction, the y-direction, or any other direction. The thermal stresses produced by the different coefficients of thermal expansion of the electronic component 1 and the circuit board 2 are concentrated on the fillet where the circuit board 2 and the electronic component 1 are coupled together, and eventually cause a crack in the fillet.

Accordingly, there is a need for a surface mounting structure for an electronic component that has sufficient reliability to prevent the generation and growth of cracks caused by the thermal stresses.

According to the present invention there is provided an apparatus and method as set forth in the appended claims. Preferred features of the invention will be apparent from the dependent claims, and the description which follows.

An aspect of the present invention is to address at least the above problems and/or disadvantages and to provide at least the advantages described below. Accordingly, an aspect of the present invention is to provide a surface mounting structure that can prevent generation and growth of a crack when stress concentrates on a soldering portion because of discrepancies in thermal expansion and contraction between a circuit substrate and an electronic component caused by different coefficients of thermal expansion.

According to an aspect of the present invention, a surface mounting structure for fixedly attaching a lead of an electronic component to a circuit board, including a land formed on the circuit board is provided. The land includes a first land portion to which a bottom surface of the lead is soldered; and a second land portion connected to the first land portion and to which an end portion of the lead is soldered. The second land portion has a greater width than the first land portion.

According to another aspect of the present invention, a surface mounting structure for fixedly attaching a lead of an electronic component to a land formed on a circuit board is provided. The land includes portions having different widths to relieve stress concentration that occurs at a soldering position because of thermal strain between the circuit board and the electronic component. The thermal strain is caused by different coefficients of thermal expansion between the circuit board and the electronic component.

According to another aspect of the present invention, a surface mounting structure for fixedly attaching a lead of an electronic component to a land formed on a circuit board is provided. The land includes portions with different widths to relieve stress concentration that occurs at a soldering position because of thermal strain between the circuit board and the electronic component. The thermal strain is caused by different coefficients of thermal expansion between the circuit board and the electronic component. One of the portions of the land, which has a width greater than other portions of the land, starts from a position corresponding to an end portion of the lead and extends outwardly beyond the end portion. The portion of the land having a larger width and another portion having a smaller width are connected together by a chamfered portion formed having one of linear edges or curved edges.

According to another aspect of the present invention, an image forming device includes a printing unit for forming an image on a print medium and a circuit board including a land to which a lead of an electronic component is soldered by a surface mounting structure. The electronic component communicates with the printing unit. The land includes a first land portion to which a bottom surface of the lead is soldered and a second land portion connected to the first land portion. An end portion of the lead is soldered to the second land portion and the second land portion has a greater width than the first land portion.

According to another aspect of the present invention, a circuit board has an electronic component mounted on a surface of the circuit board. The electronic component has at least one lead extending from the component. The lead has an end portion disposed at one end of the lead and a bottom surface and at least one land formed on the circuit board to correspond to the at least one lead. The land comprises a first land portion disposed adjacent the bottom surface of the at least one lead, and a second land portion connected to the first land portion and disposed adjacent to the end portion of the at least one lead. The second land portion having a greater width than the first land portion. A fillet formed of solder connects the at least one lead to the at least one land.

The above and other objects, features, and advantages of certain exemplary embodiments of the present invention will be more apparent from the following description taken in conjunction with the accompanying drawings, in which:
Figure 1 is a diagram showing images of a crack in a soldered fillet of a conventional surface mounting structure;
Figure 2 is a perspective view of surface mounting structures according to exemplary embodiments of the present invention;
Figures 3 and 4 are plan views of a land according to the present invention;
Figure 5 is a perspective view of a lead according to one exemplary embodiment of the present invention;
Figure 6 is a side sectional view of a second fillet of a conventional surface mounting structure and a crack therein for comparison with the present invention;
Figure 7 is a side sectional view of a second fillet according to an exemplary embodiment of the present invention;
Figure 8 is a plan view of a connection land portion according to an exemplary embodiment of the present invention;
Figure 9 is a plan view of a connection land portion having a round shape according to the present invention;
Figures 10 and 11 are plan views of an end portion of the second land having a chamfered or rounded shape according to another exemplary embodiment of the present invention; and
Figure 12 is a schematic diagram of an image forming apparatus with a surface mounting structure according to an exemplary embodiment of the present invention.

Throughout the drawings, the same reference numerals will be understood to refer to the same elements, features, and structures.

The matters defined in the description such as a detailed construction and elements are provided to assist in a comprehensive understanding of the exemplary embodiments of the invention and are merely exemplary. Accordingly, those of ordinary skill in the art will recognize that various changes and modifications of the exemplary embodiments described herein can be made without departing from the scope of the invention. Also, descriptions of well-known functions and constructions are omitted for clarity and conciseness.

The present invention will now be described more fully with reference to the accompanying drawings, in which exemplary embodiments of the invention are shown. In the drawings, the thicknesses of layers and regions are exaggerated for clarity. Also, the terms used herein are defined in accordance with the functions of the present invention. Thus, the terms may vary depending on the intent and usage. That is, the terms used herein must be interpreted based on the descriptions made herein.

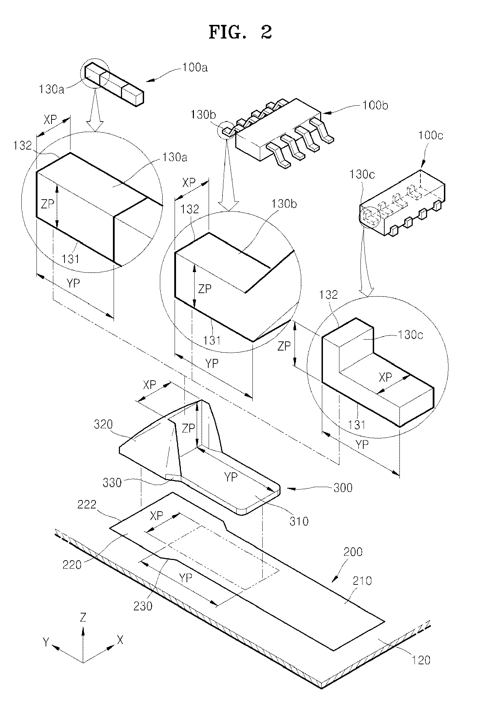

Figure 2 is a perspective view of surface mounting structures according to exemplary embodiments of the present invention. The size and proportion of circuit board 120, electronic components 100a, 100b and 100c, leads 130a, 130b and 130c, land 200, and fillet 300 have been exaggerated for clarity. The leads 130a, 130b and 130c are respectively provided to the electronic components 100a, 100b and 100c which are surface mounted on the circuit board 120. The present invention is suitable for use with any desired electronic component. For example, various types of electronic components are illustrated, including a ceramic condenser 100a having a pair of leads 130a at both ends, an electronic component 100b having a plurality of leads 130b extending outward, and an electronic component 100c having a plurality of leads 130c extending inward. Any one of the electronic components 100a, 100b and 100c may be surface mounted to the circuit board 120 by a fillet 300 formed between the land 200 and the corresponding lead 130.

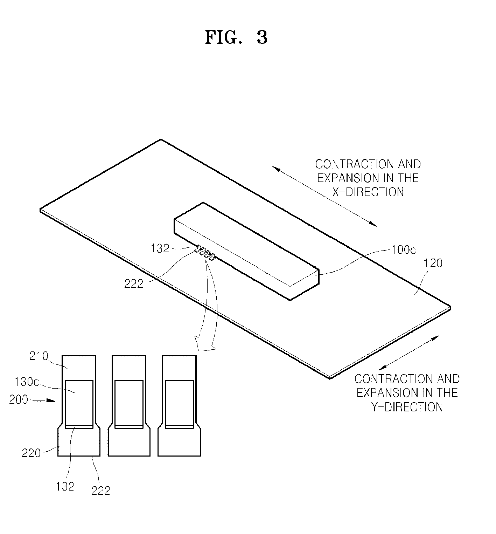

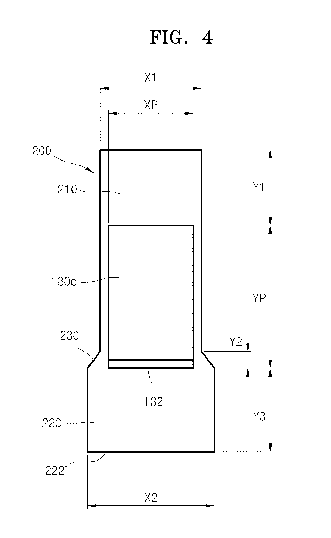

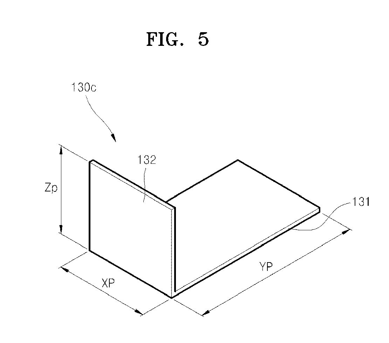

Figures 3 and 4 are plan views of the land 200 according to exemplary embodiments of the present invention. Figure 5 is a perspective view of an inward extending lead 130c of the electronic component 100c. Referring to Figure 3, the lead 130c has the shape illustrated in Figure 5, and the electronic component 100c is mounted using the lead 130c. It should be understood that although the lead 130c is used in the following description, the following description is also applicable to other types of leads, such as the leads 130a and 130b.

The surface mounting structure according to an exemplary embodiment of the present invention will now be described in detail with reference to Figures 2 to 5. The lead 130c is an input/output terminal for power and driving signals, and is soldered onto the land 200 formed on the circuit board 120. At least one lead 130c is arranged on each side of the electronic component 100c that is parallel to the x direction, and each lead 130c extends from the side of the electronic component 100c in the y direction. In the following description, the x direction will be called a first direction, and the y direction, which is substantially perpendicular to the x direction, will be called a second direction. Also, the width of lead 130c or the land 200 refers to measurements in the first direction, and the length refers to measurements in the second direction.

In the reflow process for surface mounting, a solder cream is melted, and the molten solder adheres to a bottom surface 131 and an end portion 132 of the lead 130c. The molten solder collects in a predetermined shape by surface tension and capillary action. The molten solder is cooled, forming a fillet 300. The fillet formed on the bottom surface 131 of the lead 130c is defined as a first fillet 310, and the fillet formed at the end portion 132 of the lead 130c is defined as a second fillet 320.

The lead 130c has a predetermined width (XP) in the first direction, and is soldered to a predetermined length (YP) in the second direction. The end portion 132 of the lead 130c is soldered to a predetermined height (ZP) in a z direction. The land 200 formed on the circuit board 120 includes a first land portion 210 to which the bottom surface 131 of the lead 130c is soldered, and a second land portion 220 to which the end portion 132 of the lead 130c is soldered. The first fillet 310 is formed between the bottom surface 131 of the lead 130c and the first land portion 210, and the second fillet 320 is formed between the end portion 132 of the lead 130c and the second land portion 220.

The width of the first fillet 310 is slightly greater than the width (XP) of the bottom surface 131 of the lead. The maximum height of the second fillet 320 formed by the surface tension and capillary action of the molten solder is substantially the same as the height (ZP) of the end portion 132 of the lead 130c. The length of the second fillet 320 is determined by the height (ZP) of the end portion 132 of the lead 130c and the length (Y3) of the second land portion 220.

The first land portion 210 and the second land portion 220 may be connected to each other by a connection land portion 230. A connection fillet 330 connecting the first fillet 310 and the second fillet 320 is formed on the connection land portion 230.

The first land portion 210 has a width (X1) corresponding to the width (XP) of the lead 130c so as to allow the lead 130c to be aligned in the first direction. That is, the difference between the width (X1) of the first land portion 210 and the width (XP) of the lead 130c may be relatively small. For example, the first land portion 210 and the lead 130c may have substantially the same width. Thus, the electronic component 100c or the lead 130c may be aligned in the x direction by the surface tension of the solder melt during the reflow process. Also, tomb-stoning or a Manhattan effect, where the electronic component 100c is lifted and stands on one end, or defective soldering, such as cold soldering, excessive soldering and the like can be prevented. Also, stability and reliability of soldering are improved because there is a limit in increasing the width (X1) of the first land portion 210, the second land portion 220 has a large width (X2), and the fillet 300 has a large size.

The length (Y1+YP) of the first land portion 210 may be greater than the length (YP) to which the lead 130c is soldered. Thus, the bottom surface 131 of the lead 130c may be stably mounted to the first land portion 210 which is relatively long.

The circuit board 120 and the electronic component 100c surface mounted to the circuit board 120 have different coefficients of thermal expansion. When a thermal cycle occurs, the circuit board 120 and the electronic component 100c expand and contract to different extents because of their different thermal expansion characteristics. Such a discrepancy in thermal expansion causes thermal stress to concentrate on the fillet 300 where the circuit board 120 and the electronic component 100c are coupled together. Such stress concentration results in a crack being generated in the fillet 300. An example of such a crack may be observed in detail with reference to Figure 1.

The land 200 has portions with different widths to prevent the generation of such a crack by relieving the stress concentration at the end portion 132 of the lead 130c. That is, the second land portion 220 to which the end portion 132 of the lead 130c is soldered has a greater width (X2) than the first land portion 210 to which the bottom surface 131 of the lead 130c is soldered. The connection fillet 330 is formed between the first fillet 310 formed on the first land portion 210 and the second fillet formed on the second land portion 220. The connection fillet 330 surrounds the end portion 132 of the lead 130c, so that the stress concentration can be relieved. The connection fillet 330 may be inclined with respect to the first and second directions. Also, the connection fillet 330 may be inclined with respect to the z direction.

In other words, the second land portion 220 has a greater width (X2) than the first land portion 210, and the difference in width is large enough to prevent the generation of a crack in the fillet 300. Based on results of a thermal cycling tests and various simulations, the width (X2) of the second land portion 220 may range from 1.7xXP to 1.98xXP. Here, XP represents the width of the lead 130c.

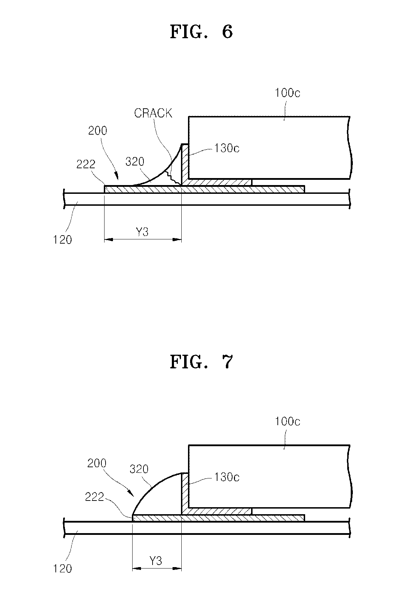

Figure 6 is a side sectional view of a second fillet 320 of a conventional surface mounting structure and a crack generated therein for comparison with the exemplary embodiments of the present invention. Figure 7 is a side sectional view of the second fillet 320 according to an exemplary embodiment of the present invention. As illustrated in Figure 6, if the length (Y3) of the second land portion 220 is excessively large, a crack may be easily generated. The crack is caused by the long recessed shape of the second fillet 320 and the crystalline structure of the solder after cooling. For this reason, as illustrated in Figure 7, the second land portion 220 of the present invention has a predetermined length (Y3) which is long enough to control a thickness and shape of the second fillet 320, thereby preventing the crack generation. Based on results of the thermal cycling test and various simulations, the second land portion 220 may have a length (Y3) ranging from 0.44 x ZP to 0.78 x ZP. Here, ZP represents the height to which the end portion 132 of the lead 130c is soldered.

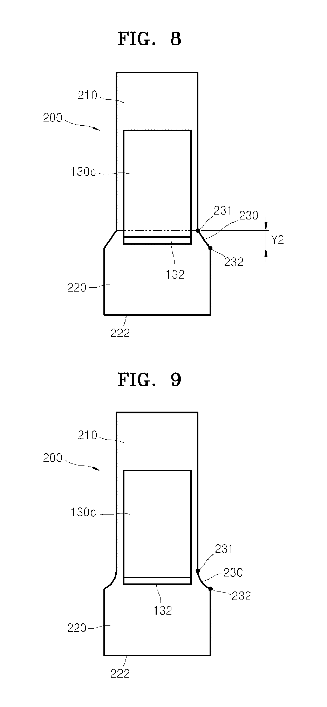

Figure 8 is a plan view illustrating a position of a connection land portion 230 according to an exemplary embodiment of the present invention. Figure 9 is a plan view of a rounded connection land portion 230 according to an exemplary embodiment of the present invention. The position and shape of the connection land portion 230 will now be described with reference to Figures 2, 8 and 9. As mentioned above, the connection fillet 330 formed on the connection land portion 230 may surround the end portion 132 of the lead 130 to relieve stress concentration. Thus, the position of the connection land portion 230 is controlled such that the end portion 132 of the lead 130c is positioned between a starting point 231 and an end point 232 of the connection land portion 230 along the second direction, the longitudinal direction of the lead 130c. The connection land portion 230 has a chamfered shape with linear edges or with curved edges, and connects the first and second land portions 210 and 220 together. Based on results of the thermal cycling test and various simulations, the length (Y2) of the connection land portion 230 may range from 0.58 x (X2-XP)/2 to 1.73 x (X2-XP)/2. Here, X2 represents the width of the second land portion 220, and XP represents the width of the lead 130c.

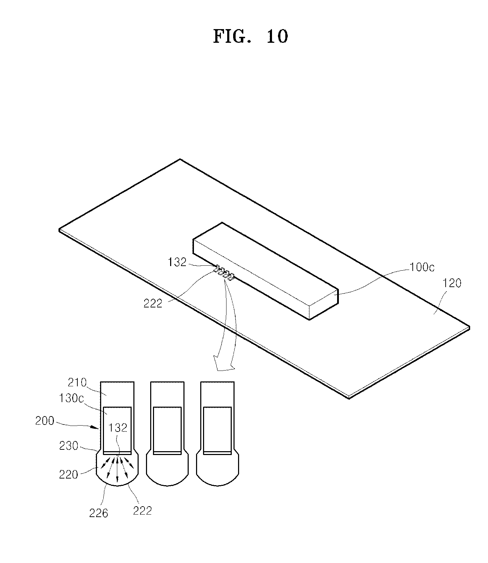

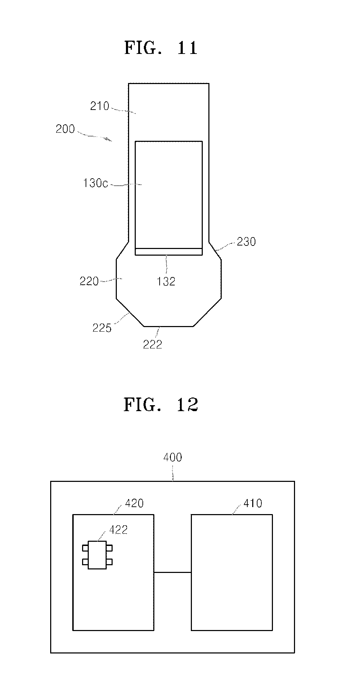

Figures 10 and 11 are plan views illustrating an end part 222 of the second land portion 220 having a chamfered or rounded shape according to another exemplary embodiment of the present invention. As described above, the thermal stress is applied to the fillet 300 in the first direction, the second direction, or any other direction. To prevent the thermal stress being applied in a random direction from concentrating on one position or in one direction, an end part 222 of the second land portion 220 may have a chamfered shape with linear edges 225 or a rounded shape with a curved edge 226. The arrows illustrated on the second land portion 220 of Figure 10 represent thermal stress vectors acting on the second fillet 320, indicating the magnitude and direction of the thermal stress.

As shown in Figure 12, the surface mounting structure for an electronic component according to the exemplary embodiments of the present invention may be used to mount electronic components on a circuit board of an image forming device. The image forming device 400 includes a printing unit 410 for printing an image on a print medium such as paper, and a circuit board 420 to which electronic components 422 for transmitting and receiving drive power, print data, control signals, and the like to the printing unit are mounted. The electronic components 422 are mounted by the described surface mounting structure of the circuit board.

Any type of printing units that print images may be used, including inkjet, electrophotographic, dye sublimation, and the like. For example, in an inkjet type printing unit, the printing unit includes a print head that sprays ink to the print medium, and a paper feeder. In an electrophotographic type printing unit, the printing unit includes a photoconductive body for forming an electrostatic latent image when exposed by an exposure unit, a developer unit for developing the electrostatic latent image into a toner image, a transfer roller for transferring the toner image to the print medium, and a fuser device for fusing the toner image using heat and pressure.

The circuit board may be used for any purpose, such as a power supply board for supplying power or a bias voltage for the electrophotographic printing, an interface board for inputting and outputting data between the printing unit and a host computer, a main circuit board for controlling the operation of each component of the printing unit and processing data, or an optional circuit board which is typically purchased separately from an image forming device to add functions such as faxing and the like.

The surface mounting structure according to the exemplary embodiments of the present invention has at least some of the following advantages.

First, a lead may be aligned at a proper position by controlling the width of the first land portion. The second land portion has a large width, to increase the stability and reliability of soldering.

The shape and location of the connection land portion minimize or prevent crack generation in the fillet.

Stress concentration may be minimized or prevented because the end part of the second land portion is chamfered or rounded.

Accordingly, the stability and reliability of the surface mounting structure may be ensured while utilizing a small area of the circuit board without incurring additional cost or installing a separate structure.

Although a few preferred embodiments have been shown and described, it will be appreciated by those skilled in the art that various changes and modifications might be made without departing from the scope of the invention, as defined in the appended claims.

Attention is directed to all papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings) may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. A surface mounting structure for fixedly attaching a lead (130) of an electronic component (100) to a circuit board (120), the surface mounting structure comprising a land (200) formed on the circuit board (120), wherein the land (200) comprises:
a first land portion (210) to which a bottom surface (131) of the lead (130) is soldered; and
a second land portion (220) connected to the first land portion (210), wherein an end portion (132) of the lead (130) is soldered to the second land portion (220) and the second land portion (220) has a greater width than the first land portion (210).

2. The surface mounting structure of claim 1, wherein:
the lead (130) has a width along a first direction, and extends from the electronic component (100) along a second direction,
the first land portion (210) has a width corresponding to that of the lead (130) to align the lead (130) in the first direction, and
the second land portion (220) is wider than the first land portion (210) by a width large enough to prevent crack generation in a fillet (300) formed by soldering.

3. The surface mounting structure of claim 2, wherein the width of the second land portion (220) ranges from 1.7 x XP to 1.98 x XP, wherein XP is the width of the lead (130).

4. The surface mounting structure of claim 2 or 3, wherein the second land portion (220) is long enough to control a thickness and a shape of the fillet (300) formed at the end portion (132) of the lead (130).

5. The surface mounting structure of claim 4, wherein the length of the second land portion (220) ranges from 0.44xZP to 0.78xZP, where ZP is a height to which the end portion (132) of the lead (130) is soldered.

6. The surface mounting structure of claim 2, 3, 4 or 5, wherein the second land portion (220) comprises an end part (222) having a chamfered or rounded shape to relieve stress concentration in the fillet (300).

7. The surface mounting structure of any preceding claim, wherein the length of the first land portion (210) is greater than a length to which the lead (130) is soldered.

8. The surface mounting structure of any preceding claim, further comprising a connection land portion (230) for connecting the first land portion (210) and the second land portion (220), the connection land portion (230) having a chamfered shape formed by one of linear edges or curved edges.

9. The surface mounting structure of claim 8, wherein a connection fillet (330) is formed on the connection land portion (230) to connect a first fillet (310) formed on the first land portion (210) with a second fillet (320) formed on the second land portion (220).

10. The surface mounting structure of claim 9, wherein the connection fillet (330) is formed so that the end portion (132) of the lead (130) is surrounded by a combination of the connection fillet (330) and the second fillet (320).

11. The surface mounting structure of claim 8, 9 or 10, wherein the end portion (132) of the lead (130) is placed between a starting point and an end point of the connection land portion (230) along a longitudinal direction of the lead (130).

12. The surface mounting structure of claim 8, 9, 10 or 11, wherein the connection land portion (230) has a length ranging from 0.58 x (X2-XP)/2 to 1.73x (X2-XP) /2, where X2 is the width of the second land portion (220), and XP is the width of the lead (130).

13. A surface mounting structure for fixedly attaching a lead (130) of an electronic component (100) to a circuit board (120), the surface mounting structure comprising:
a land (200) formed on the circuit board (120), the land (200) comprising portions having different widths to relieve stress concentrations that occur at a soldering position because of thermal strain between the circuit board (120) and the electronic component (100).

14. The surface mounting structure of claim 13, wherein the thermal strain is caused by different coefficients of thermal expansion of the circuit board (120) and the electronic component (100).

15. The surface mounting structure of claim 13 or 14, wherein:
a first fillet (310) is formed where a bottom surface (131) of the lead (130) is soldered,
a second fillet (320) is formed where an end portion (132) of the lead (130) is soldered, and
a connection fillet (330) surrounds the end portion (132) of the lead (130) and connects the first fillet (310) and the second fillet (320) together.

16. The surface mounting structure of claim 15, wherein the lead (130) has a width along a first direction and extends from the electronic component (100) along a second direction, and the connection fillet (330) is inclined with respect to the first direction and the second direction.

17. The surface mounting structure of claim 15 or 16, wherein the land (200) includes:
a first land portion (210) having a length greater than a length to which the lead (130) is soldered, and on which the first fillet (310) is formed;
a second land portion (220) which is long enough to control a thickness and a shape of the second fillet (320), and on which the second fillet (320) is formed; and
a connection land portion (230) that connects the first land portion (210) with the second land portion (220), and on which the connection fillet (330) is formed.

18. The surface mounting structure of claim 17, wherein the connection land portion (230) has a chamfered shape with one of linear edges or curved edges

19. The surface mounting structure of claim 15, 16, 17 or 18, wherein the second land portion (220) comprises an end portion (132) with one of a chamfered or rounded shape to relieve stress concentration at the second fillet (320).

20. A surface mounting structure for fixedly attaching a lead (130) of an electronic component (100) to a circuit board (120), the surface mounting structure comprising:
a land (200) formed on the circuit board (120), the land (200) having portions with different widths to relieve stress concentration that occurs at a soldering position because of thermal strain between the circuit board (120) and the electronic component (100), wherein
one of the portions of the land (200) that starts from a position corresponding to an end portion (132) of the lead (130) and extends outwardly beyond the end portion (132) has a width greater than other portions of the land (200), and
the portion of the land (200) having a greater width is connected to a portion having a smaller width by a chamfered portion.

21. The surface mounting structure of claim 20, wherein the thermal strain is caused by different coefficients of thermal expansion of the circuit board (120) and the electronic component (100).

22. The surface mounting structure of claim 20 or 21, wherein the chamfered portion has one of linear edges or curved edges.

23. An image forming device comprising:
a printing unit for forming an image on a print medium; and
a circuit board (120) including a land (200) to which a lead (130) of an electronic component (100) is soldered by a surface mounting structure, the electronic component (100) communicating with the printing unit, wherein the land (200) includes:
a first land portion (210) to which a bottom surface (131) of the lead (130) is soldered; and
a second land portion (220) connected to the first land portion (210), wherein an end portion (132) of the lead (130) is soldered to the second land portion (220) and the second land portion (220) has a greater width than the first land portion (210).

24. The image forming device of claim 23, wherein:
the lead (130) has a width along a first direction, and extends from the electronic component (100) along a second direction,
the first land portion (210) has a width corresponding to that of the lead (130) to align the lead (130) in the first direction, and
the second land portion (220) is wider than the first land portion (210) by a width large enough to prevent crack generation in a fillet (300) formed by soldering.

25. A circuit board (120) having an electronic component (100) mounted on a surface of the circuit board (120), comprising:
at least one lead (130) extending from the electronic component (100), the lead (130) having an end portion (132) disposed at one end of the lead (130) and a bottom surface (131);
at least one land (200) formed on the circuit board (120) to correspond to the at least one lead (130), the land (200) comprising a first land portion (210) disposed adjacent the bottom surface (131) of the at least one lead (130), and a second land portion (220) connected to the first land portion (210) and disposed adjacent to the end portion (132) of the at least one lead (130), the second land portion (220) having a greater width than the first land portion (210); and
a fillet (300) formed of solder that connects the at least one lead (130) to the at least one land (200).

26. The circuit board (120) of claim 25, wherein the fillet (300) comprises:
a first fillet (310) that connects the bottom surface (131) of the at least one lead (130) to the first land portion (210); and
a second fillet (320) that connects the end portion (132) of the at least one lead (130) to the second land portion (220) .

27. The circuit board (120) of claim 25 or 26, wherein the width of the at least one lead (130) and the width of the first land portion (210) are substantially equal.

28. The circuit board (120) of claim 25, 26 or 27, wherein the second land portion (220) is wider than the first land portion (210) by a width large enough to prevent crack generation in the fillet (300).

29. The circuit board (120) of claim 28, wherein the width of the second land portion (220) ranges from 1.7xXP to 1.98xXP, wherein XP is the width of the lead (130).

30. The circuit board (120) of any of claims 25 to 29, wherein the second land portion (220) is long enough to control a thickness and a shape of the fillet (300) formed at the end portion (132) of the lead (130).

31. The circuit board (120) of claim 30, wherein the length of the second land portion (220) ranges from 0.44 x ZP to 0.78 x ZP, where ZP is a height to which the end portion (132) of the lead (130) is soldered.

32. The circuit board (120) of any of claims 25 to 31, wherein the second land portion (220) comprises an end part (222) having a chamfered or rounded shape to relieve stress concentration in the fillet (300).

33. The circuit board (120) of any of claims 25 to 32, wherein the length of the first land portion (210) is greater than a length to which the lead (130) is soldered.

34. The circuit board (120) of any of claims 25 to 33, further comprising a connection land portion (230) for connecting the first land portion (210) and the second land portion (220).

35. The circuit board (120) of claim 34, wherein the connection land portion (230) has a chamfered shape formed by one of linear edges or curved edges.

36. The circuit board (120) of claim 34 or 35, further comprising:
a first fillet (310) that connects the bottom surface (131) of the at least one lead (130) to the first land portion (210);
a second fillet (320) that connects the end portion (132) of the at least one lead (130) to the second land portion (220); and
a connection fillet (330) formed on the connection land portion (230) to connect the first fillet (310) and the second fillet (320).

37. The circuit board (120) of claim 34, 35 or 36, wherein the end portion (132) of the lead (130) is placed in the connection land portion (230).

38. The circuit board (120) of claim 34, 35, 36 or 37, wherein the connection land portion (230) has a length ranging from 0.58 x (X2-XP)/2 to 1.73 x (X2-XP) /2, where X2 is the width of the second land portion (220), and XP is the width of the lead (130).
